Europäisches Patentamt

European Patent Office

Office européen des brevets

(19)

(11) Veröffentlichungsnummer: **0 161 409**
A2

(12) # EUROPÄISCHE PATENTANMELDUNG

(21) Anmeldenummer: 85102686.4

(22) Anmeldetag: 09.03.85

(51) Int. Cl.⁴: **F 42 C 19/00,** F 42 C 19/06,
C 23 C 14/34

(30) Priorität: 22.03.84 DE 3410472

(71) Anmelder: **DIEHL GMBH & CO., Stephanstrasse 49,
D-8500 Nürnberg (DE)**

(43) Veröffentlichungstag der Anmeldung: 21.11.85
**Patentblatt 85/47**

(72) Erfinder: **Stützle, Dietmar, Dr., Erlenstrasse 7,
D-8560 Lauf/Pegnitz (DE)**

(74) Vertreter: **Hofmann, Gerhard, Dipl.-Ing. et al,
Stephanstrasse 49, D-8500 Nürnberg (DE)**

(84) Benannte Vertragsstaaten: **BE DE FR GB IT NL SE**

(54) **Mehrteiliger Geschoss-Zünder.**

(57) Ein mehrteiliger Geschoß-Zünder soll aus kostengünstig herstellbaren Einzelteilen bestehen. Dafür ist vorgesehen, Zünder-Teile – gleichgültig, ob es sich z.B. um Metallteile oder um Kunststoff-Gußteile handelt – mit einer im Wege der Kathoden-Zerstäubung aufgebrachten Oberflächen-Metallisierung als abriebfestem Schutz gegen Umwelteinflüsse und als elektrischen Schutzschirm gegen Einstreuen elektrischer Felder zu versehen. Insbesondere solche Oberflächen-Bereiche, die nach dem Zusammenbau der Zünder-Einzelteile als elektrische (ohmsche) Kontaktstrecken dienen, weisen zweckmäßigerweise zusätzlich eine Vergoldung auf.

ACTORUM AG

P 759 Euro
Fg/Lu

DIEHL GMBH & CO., D-8500 Nürnberg

Mehrteiliger Geschoß-Zünder

Die Erfindung betrifft einen mehrteiligen Geschoß-Zünder gemäß dem Oberbegriff des Patentanspruches 1.

Derartige Zünder bestehen aus zahlreichen, getrennt gefertigten und dann zusammengebauten Einzelteilen, die im einsatzfertigen Zusatz teils starr miteinander verbunden sind, teils gegeneinander beweglich sind, wie beispielsweise in der DE-OS 30 49 082 dargestellt.

Die einzelnen, betriebsfertig zusammengebauten Zünder-Teile sind größtenteils spanend aus metallenem Halbzeug hergestellt. Aufgrund der außerordentlich hohen Ansprüche an die Zünder-Funktionstüchtigkeit auch noch nach langer Lagerzeit unter ungünstigen Umgebungsbedingungen erfahren die einzelnen Zünder-Teile vor ihrem Zusammenbau in der Regel eine Oberflächenbehandlung, die insbesondere aggresive korrodierende Umwelteinflüsse abhalten soll, bereichsweise aber auch als elektrisch leitende Abschirmschicht oder Kontaktfläche funktionell benötigt wird.

Die Oberflächenbehandlung besteht normalerweise in einem Cadmieren, da die sich ausbildende Schutzschicht sehr korrosionsfest ist. Allerdings ist sie andererseits nicht besonders abriebfest; diese Behandlung ist aber auch technologisch sehr kritisch, da hochgiftige Substanzen verarbeitet werden, was entsprechenden Aufwand im Bereiche des Arbeits- und Umweltschutzes erfordert. Da die durch Cadmieren erhältliche Schutzschicht elektrisch nur schlecht leitend ist, sind für Kontaktierungsbereiche zusätzliche Leitschichten aufzubringen, wenn z. B. Zünder-Teile im Sandwich-Aufbau mit dazwischenliegenden Piezokeramik-Scheiben elektrisch zusammenzuschalten sind. Das Aufbringen von elektrischen Leitschichten auf diese Schicht ist fertigungstechnisch ebenfalls nicht ganz problemlos.

Galvanische Nassverfahren zur Oberflächenbehandlung, wie insbesondere das Verkupfern mit anschließendem Vergolden, werden fertigungstechnisch zunehmend problematisch, da die steigenden Anforderungen an den Umweltschutz bei der Errichtung und dem Betrieb der erforderlichen Anlagen außerordentlich hohe Kostensteigerungen bedingen.

In Erkenntnis dieser Gegebenheiten liegt der Erfindung die Aufgabe zugrunde, gattungsgemäße Geschoß-Zünder aus Teilen herstellen zu können, die technologisch weniger aufwendig fertig- und behandelbar sind und dennoch die erörterten Oberflächeneigenschaften erbringen.

Diese Aufgabe wird erfindungsgemäß im wesentlichen dadurch gelöst, daß die Geschoß-Zünder aus Teilen gemäß dem kennzeichnenden Teil des Patentanspruches 1 bestehen. Nach diesem grundlegenden Lösungsgedanken eröffnen sich insbesondere auch günstige Möglichkeiten, unter Abkehr von der mechanischen, spanenden Fertigung weitgehend auf Kunststoff-Gußtechniken zur Herstellung von Zünder-Teilen zurückzugreifen, die angesichts der verfügbaren Palette von Kunststoff-Rohmaterialien allen Anforderungen an Maßgenauigkeit und mechanischer Festigkeit sowie Bearbeitbarkeit

...3

genügen. Dabei wird, wie im Falle von Metallteilen, auf Oberflächen der Kunststoff-Teile eine sehr dünne aber mechanisch extrem beanspruchbare Metallisierung im Wege der elektrischen Kathodenzerstäubung aufgebracht, die also die Maßgerechtigkeit der zuvor gefertigten Kunststoff-Zünderteile nicht mehr beeinträchtigt und dabei gleichermaßen eine feste, überaus abriebfeste, dichte und auch schon elektrisch gut leitende, also gegen elektrische Störeinstrahlungen abschirmende Beschichtung ergibt.

Die elektrische Kathodenzerstäubung zur Verdampfungs-Aufbringung feinster, geschlossener metallischer Schichten ist als solche bekannt (vgl. Lueger, Band 16: Lexikon der Verfahrenstechnik, 1970, Seite 44); insbesondere zur Substrat-Metallisierung bei der Herstellung integrierter Halbleiter-Bauelemente. Aber auch zur Metallisierung größerer Körper wird das Verfahren der Kathodenzerstäubung bereits beherrscht.

Eine besonders abriebfeste Metallisierung der Oberflächen auch von Kunststoff-Zünderteilen ergibt sich beim Aufdampfen von Titannitrid durch Elektronenstrahlzerstäubung von Titan in Feinvakuum-Atmosphäre. Diese gut haftende, chemisch beständige Schutzschicht ist bereits elektrisch leitend, eignet sich darüberhinaus aber auch vorzüglich als Unterlage zum Aufbringen z. B. einer zusätzlichen Vergoldung. Für geometrisch definierte elektrische Kontaktierungsbereiche über bestimmten Regionen von Zünderteil-Oberflächen ist diese Eigenschaft von zusätzlichem Vorteil.

P 759
Fg/Lu

0161409

Patentansprüche:

1. Mehrteiliger Geschoß-Zünder mit Teilen, deren Oberflächen antikorrosiv behandelt sind,
dadurch gekennzeichnet,
daß wenigstens einige der Zünder-Teile auf Oberflächen im Wege der elektrischen Kathoden-Zerstäubung metallisch beschichtet sind.

2. Geschoß-Zünder nach Anspruch 1,
dadurch gekennzeichnet,
daß die Oberflächen-Beschichtung aus Titannitrid besteht

3. Geschoß-Zünder nach einem der vorangehenden Ansprüche,
dadurch gekennzeichnet,
daß Bereiche der Oberflächen-Beschichtung vergoldet sind.